# EUROPEAN PATENT APPLICATION

(11) **EP 2 838 026 A2**
(43) Date of publication of application: **18.02.2015**
(21) Application number: 14180419.5
(22) Date of filing: 08.08.2014
(51) Int. Cl.: G06F 12/02, G06F 13/16, G06F 3/06

(54) **Trim mechanism using multi-level mapping in a solid-state media**

(30) Priority: 09.08.2013 US 201313963074
(71) Applicant: LSI Corporation, San Jose, CA 95131 (US)
(72) Inventor: Baryudin, Leonid, San Jose, CA 95124 (US); Cohen, Earl T., Oaklans, CA 94618 (US)
(74) Representative: Dilg, Haeusler, Schindelmann Patentanwaltsgesellschaft mbH

(57) **Abstract**

Described embodiments provide a media controller that receives requests that include a logical address and address range. In response to the request, the media controller determines whether the received request is an invalidating request. If the received request type is an invalidating request, the media controller uses a map to determine one or more entries of the map associated with the logical address and range. Indicators in the map associated with each of the map entries are set to indicate that the map entries are to be invalidated. The media controller acknowledges to a host device that the invaliding request is complete and updates, in an idle mode of the media controller, a free space count based on the map entries that are to be invalidated. The physical addresses associated with the invalidated map entries are made available to be reused for subsequent requests from the host device.

## Description

### Cross-Reference to Related Applications

This application is a continuation-in-part, and claims the benefit of the filing date, of International Patent Application no. PCT/US2012/049905 filed August 8, 2012, the teachings of which are incorporated herein in their entireties by reference.

This application claims the benefit of the filing date of U.S. provisional patent application no. 61/783,555 filed March 14, 2013, the teachings of which are incorporated herein in their entireties by reference.

The subject matter of this application is related to U.S. patent application nos. 13/464,433 filed May 4, 2012, 13/567,025 filed August 4, 2012, 13/600,464 filed August 31, 2012, 13/729,966 filed December 28, 2012, and 13/748,260 filed January 23, 2013, the teachings of which are incorporated herein in their entireties by reference.

### BACKGROUND

Flash memory is a non-volatile memory (NVM) that is a specific type of electrically erasable programmable read-only memory (EEPROM). One commonly employed type of flash memory technology is NAND flash memory. NAND flash memory requires small chip area per cell and is typically divided into one or more banks or planes. Each bank is divided into blocks; each block is divided into pages. Each page includes a number of bytes for storing user data, error correction code (ECC) information, or both.

There are three basic operations for NAND devices: read, write and erase. The read and write operations are performed on a page-by-page basis. Page sizes are generally 2*^{N}* bytes of user data (plus additional bytes for ECC information), where *N* is an integer, with typical user data page sizes of, for example, 2,048 bytes (2KB), 4,096 bytes (4KB), 8,192 bytes (8KB) or more per page. A "read unit" is the smallest amount of data and corresponding ECC information that can be read from the NVM and corrected by the ECC, and might typically be between 4K bits and 32K bits (e.g., there is generally an integer number of read units per page). Pages are typically arranged in blocks, and an erase operation is performed on a block-by-block basis. Typical block sizes are, for example, 64, 128 or more pages per block. Pages must be written sequentially, usually from a low address to a high address within a block. Lower addresses cannot be rewritten until the block is erased. Associated with each page is a spare area (typically 100 - 640 bytes) generally used for storage of ECC information and/or other metadata used for memory management. The ECC information is generally employed to detect and correct errors in the user data stored in the page, and the metadata might be used for mapping logical addresses to and from physical addresses. In NAND flash chips with multiple banks, multi-bank operations might be supported that allow pages from each bank to be accessed substantially in parallel.

NAND flash memory stores information in an array of memory cells made from floating gate transistors. These transistors hold their voltage level, also referred to as charge, for long periods of time, on the order of months or years, without external power being supplied. In single-level cell (SLC) flash memory, each cell stores one bit of information. In multi-level cell (MLC) flash memory, each cell can store more than one bit per cell by choosing between multiple levels of electrical charge to apply to the floating gates of its cells. MLC NAND flash memory employs multiple voltage levels per cell with a serially linked transistor arrangement to allow more bits to be stored using the same number of transistors. Thus, considered individually, each cell has a particular programmed charge corresponding to the logical bit value(s) stored in the cell (e.g., 0 or 1 for SLC flash; 00, 01, 10, 11 for MLC flash), and the cells are read based on one or more threshold voltages for each cell. However, increasing the number of bits per cell increases cell-to-cell interference and retention noise, increasing the likelihood of read errors and, thus, the bit error ratio (BER) of the system. Further, the read threshold voltages of each cell change over operating time of the NVM, for example due to read disturb, write disturb, retention loss, cell aging and process, voltage and temperature (PVT) variations, also increasing BER.

As described, typical NVMs require that a block be erased before new data can be written to the block. Thus, NVM systems, such as solid-state disks (SSDs) employing one or more NVM chips, typically periodically initiate a "garbage collection" process to erase data that is "stale" or out-of-date to prevent the flash memory from filling up with data that is mostly out-of-date, which would reduce the realized flash memory capacity. However, NVM blocks can be erased only a limited number of times before device failure. For example, a SLC flash might only be able to be erased on the order of 100,000 times, and a MLC flash might only be able to be erased on the order of 10,000 times. Therefore, over the operational life (e.g., over a rated number of program/erase (P/E) cycles for NAND flash) of an NVM, the NVM wears and blocks of flash memory will fail and become unusable. Block failure in NVMs is analogous to sector failures in hard disk drives (HDDs). Typical NVM systems might also perform wear-leveling to distribute, as evenly as possible, P/E cycles over all blocks of the NVM. Thus, over the lifetime of an NVM system, the overall storage capacity might be reduced as the number of bad blocks increases and/or the amount of storage used for system data requirements (e.g., logical-to-physical translation tables, logs, metadata, ECC, etc.) increases. Thus, it can be important to reduce the amount of data written to the NVM during the garbage collection process.

During the garbage collection process, user data in a block which is still valid is moved to new location on the storage media in a background process. "Valid" user data might be any address that has been written at least once, even if the host device is no longer using this data. To reduce the amount of "valid" but no longer needed data that is rewritten during garbage collection, some storage protocols support commands that enable an NVM to designate blocks of previously saved data as unneeded or invalid such that the blocks are not moved during garbage collection, and the blocks can be made available to store new data. Examples of such commands are the SATA TRIM (Data Set Management) command, the SCSI UNMAP command, the MultiMediaCard (MMC) ERASE command, and the Secure Digital (SD) card ERASE command. Generally, such commands improve NVM performance such that a fully trimmed NVM has performance approaching that of a newly manufactured (i.e., empty) NVM of the same type. However, performing these commands for large numbers of blocks at once can be time consuming and reduce operating efficiency of the NVM.

### SUMMARY

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.

Described embodiments provide a media controller for a solid-state media. The media controller includes a control processor receives a request from a host device that includes at least one logical address and address range. In response to the request, the control processor determines whether the received request is an invalidating request. If the received request type is an invalidating request, the control processor uses a map of the media controller to determine one or more entries of the map associated with the logical address and range. Indicators in the map associated with each of the map entries are set to indicate that the map entries are to be invalidated. The control processor acknowledges to the host device that the invaliding request is complete and updates, in an idle mode of the media controller, a free space count based on the map entries that are to be invalidated. The physical addresses associated with the invalidated map entries are made available to be reused for subsequent requests from the host device.

### BRIEF DESCRIPTION OF THE DRAWING FIGURES

Other aspects, features, and advantages of described embodiments will become more fully apparent from the following detailed description, the appended claims, and the accompanying drawings in which like reference numerals identify similar or identical elements.
FIG. 1 shows a block diagram of a flash memory storage system in accordance with exemplary embodiments;
FIG. 2 shows an exemplary functional block diagram of a single standard flash memory cell;
FIG. 3 shows an exemplary NAND MLC flash memory cell in accordance with exemplary embodiments;
FIG. 4 shows a block diagram of an exemplary arrangement of the flash memory of the flash memory storage system of FIG. 1;

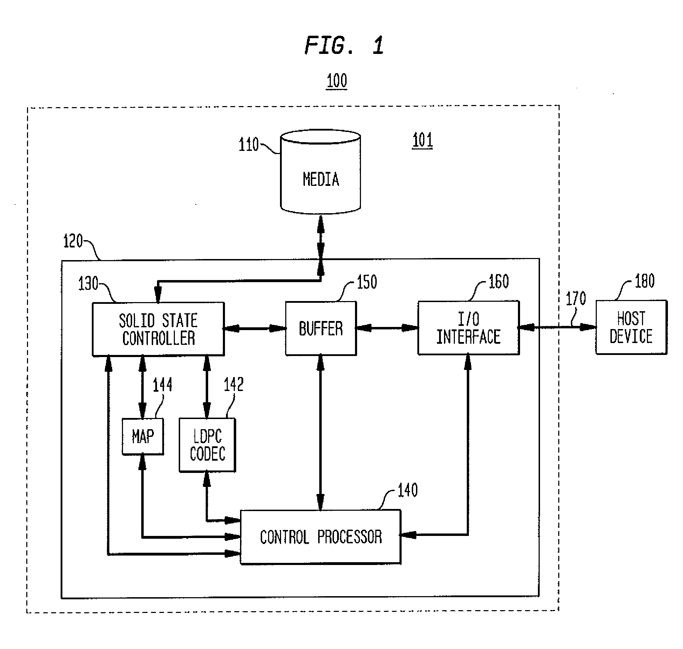

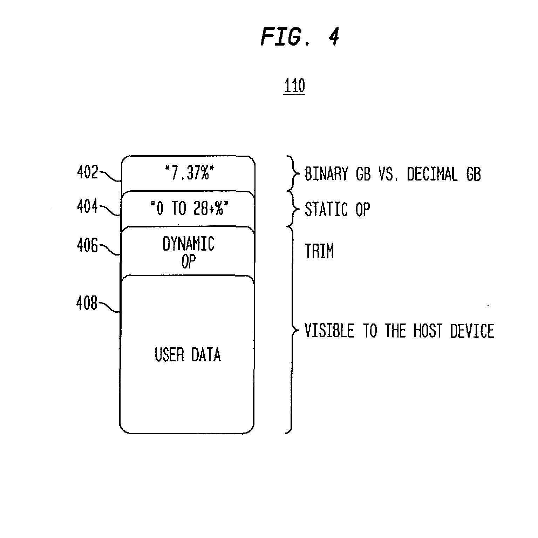

FIG. 4 shows a block diagram of an exemplary arrangement of the solid state media of the flash memory storage system of FIG. 1;

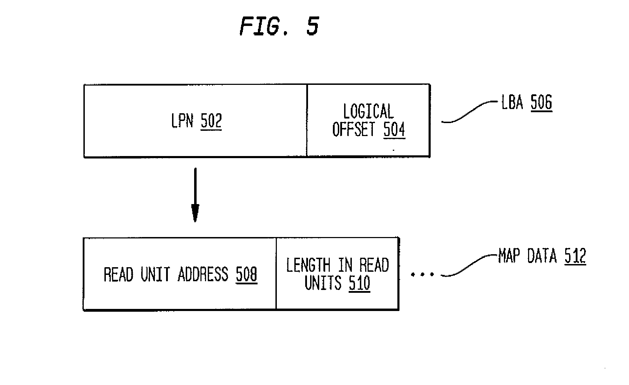

FIG. 5 shows a block diagram of an exemplary mapping of a logical page number (LPN) portion of a logical block number (LBA) of the flash memory storage system of FIG. 1;

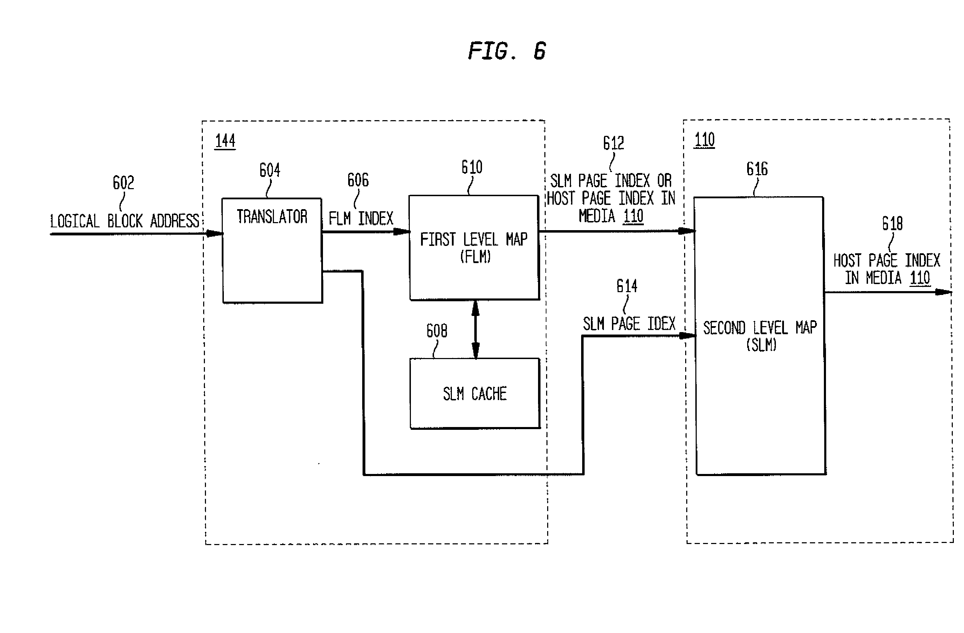

FIG. 6 shows a block diagram of an exemplary two-level mapping structure of the flash memory storage system of FIG. 1;

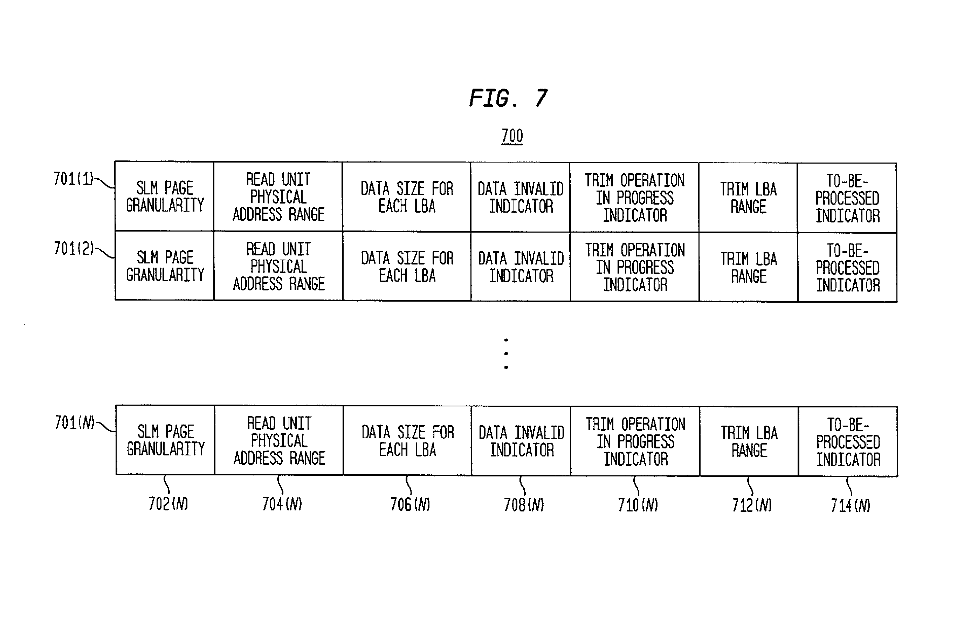

FIG. 7 shows a block diagram of exemplary map page headers employed by the flash memory storage system of FIG. 1; and

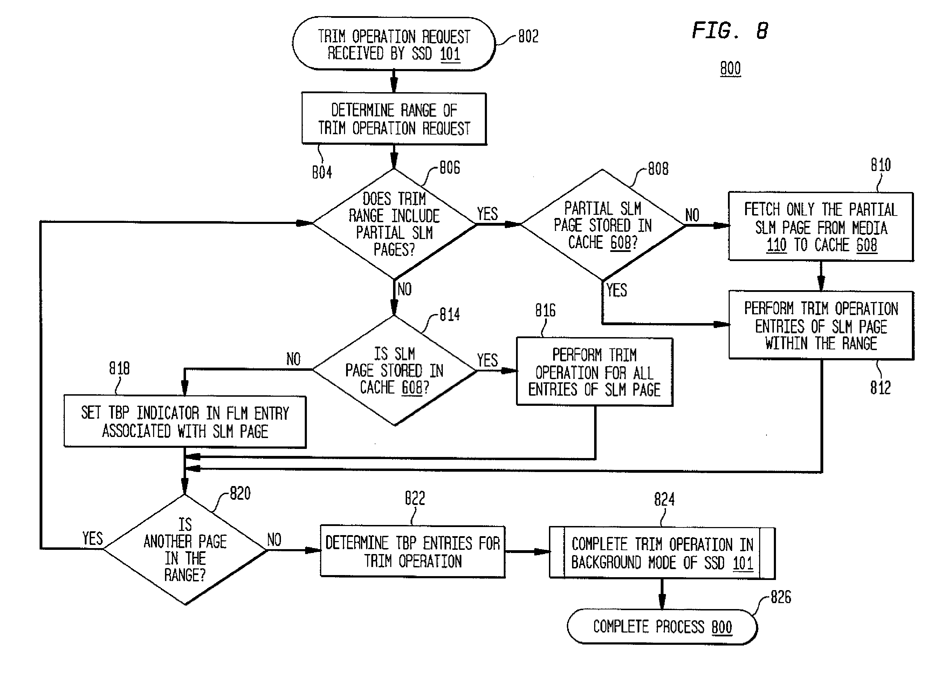

FIG. 8 shows an exemplary flow diagram of a Mega-TRIM operation employed by the flash memory storage system of FIG. 1.

### DETAILED DESCRIPTION

Described embodiments provide a media controller for a solid-state media. The media controller includes a control processor receives a request from a host device that includes at least one logical address and address range. In response to the request, the control processor determines whether the received request is an invalidating request. If the received request type is an invalidating request, the control processor uses a map of the media controller to determine one or more entries of the map associated with the logical address and range. Indicators in the map associated with each of the map entries are set to indicate that the map entries are to be invalidated. The control processor acknowledges to the host device that the invaliding request is complete and updates, in an idle mode of the media controller, a free space count based on the map entries that are to be invalidated. The physical addresses associated with the invalidated map entries are made available to be reused for subsequent requests from the host device.

**Table 1** defines a list of acronyms employed throughout this specification as an aid to understanding the described embodiments:

| **TABLE 1** | | | | |
|---|---|---|---|---|
| BER | Bit Error Rate | | BUS | Block Used Space |
| CAM | Content Addressable Memory | | ECC | Error Correction Code |
| eDRAM | Embedded Dynamic Random Access Memory | | EEPROM | Electrically Erasable Programmable Read-Only Memory |
| FLM | First Level Map | | HDD | Hard Disk Drive |
| IC | Integrated Circuit | | I/O | Input/Output |
| LBA | Logical Block Address | | LDPC | Low-Density Parity-Check |
| LLR | Log-Likelihood Ratio | | LPN | Logical Page Number |
| LSB | Least Significant Bit | | LRU | Least Recently Used |
| MLC | Multi-Level Cell | | MLM | Multi-Level Map |
| MMC | MultiMediaCard | | MSB | Most Significant Bit |
| NVM | Non-Volatile Memory | | OOS | Out-Of-Space |
| OP | Over Provisioning | | PCI-E | Peripheral Component Interconnect Express |
| P/E | Program/Erase | | PVT | Process, Voltage, Temperature |
| SAS | Serial Attached SCSI | | SATA | Serial Advanced Technology Attachment |
| SCSI | Small Computer System Interface | | SD | Secure Digital |
| SLC | Single Level Cell | | SLM | Second Level Map |
| SoC | System on Chip | | SRAM | Static Random Access Memory |
| SRIO | Serial Rapid Input/Output | | SSD | Solid-State Disk |
| TBP | To-Be-Processed | | USB | Universal Serial Bus |

FIG. 1 shows a block diagram of non-volatile memory (NVM) storage system **100.** NVM storage system **100** includes media **110,** which is coupled to media controller **120.** Media **110** might be implemented as a NAND flash solid-state disk (SSD), a magnetic storage media such as a hard disk drive (HDD), or as a hybrid solid-state and magnetic system. Although not shown in FIG. 1, media **110** might typically include one or more physical memories (e.g., non-volatile memories, NVMs), such as multiple flash chips. As shown in FIG. 1, media **110** and media controller **120** are collectively SSD **101.** Media controller **120** includes solid-state controller **130,** control processor **140,** buffer **150** and I/O interface **160.** Media controller **120** controls transfer of data between media **110** and host device **180** that is coupled to communication link **170.** Media controller **120** might be implemented as a system-on-chip (SoC) or other integrated circuit (IC). Solid-state controller **130** might be used to access memory locations in media **110,** and might typically implement low-level, device specific operations to interface with media **110.** Buffer **150** might be a RAM buffer employed to act as a cache for control processor **140** and/or as a read/write buffer for operations between solid-state media **110** and host device **180.** For example, data might generally be temporarily stored in buffer **150** during transfer between solid-state media **110** and host device **180** via I/O interface **160** and link **170.** Buffer **150** might be employed to group or split data to account for differences between a data transfer size of communication link **170** and a storage unit size (e.g., read unit size, page size, sector size, or mapped unit size) of media **110.** Buffer **150** might be implemented as a static random-access memory (SRAM) or as an embedded dynamic random-access memory (eDRAM) internal to media controller **120,** although buffer **150** could also include memory external to media controller **120** (not shown), which might typically be implemented as a double-data-rate (e.g., DDR-3) DRAM.

Control processor **140** communicates with solid-state controller **130** to control data access (e.g., read or write operations) data in media **110.** Control processor **140** might be implemented as one or more Pentium®, Power PC®, Tensilica® or ARM processors, or a combination of different processor types (Pentium® is a registered trademark of Intel Corporation, Tensilica® is a trademark of Tensilica, Inc., ARM processors are by ARM Holdings, plc, and Power PC® is a registered trademark of IBM). Although shown in FIG. 1 as a single processor, control processor **140** might be implemented by multiple processors (not shown) and include software/firmware as needed for operation, including to perform threshold optimized operations in accordance with described embodiments. Control processor **140** is in communication with low-density parity-check (LDPC) coder/decoder (codec) **142,** which performs LDPC encoding for data written to media **110** and decoding for data read from media **110.** Control processor **140** is also in communication with map **144,** which is used to translate between logical addresses of host operations (e.g., logical block addresses (LBAs) for read/write operations, etc.) and physical addresses on media **110.** As employed herein, the term LBA is synonymous with HPA (Host Page Address).

Communication link **170** is used to communicate with host device **180,** which might be a computer system that interfaces with NVM system **100.** Communication link **170** might be a custom communication link, or might be a bus that operates in accordance with a standard communication protocol such as, for example, a Small Computer System Interface ("SCSI") protocol bus, a Serial Attached SCSI ("SAS") protocol bus, a Serial Advanced Technology Attachment ("SATA") protocol bus, a Universal Serial Bus ("USB"), an Ethernet link, an IEEE 802.11 link, an IEEE 802.15 link, an IEEE 802.16 link, a Peripheral Component Interconnect Express ("PCI-E") link, a Serial Rapid I/O ("SRIO") link, or any other similar interface link for connecting a peripheral device to a computer.

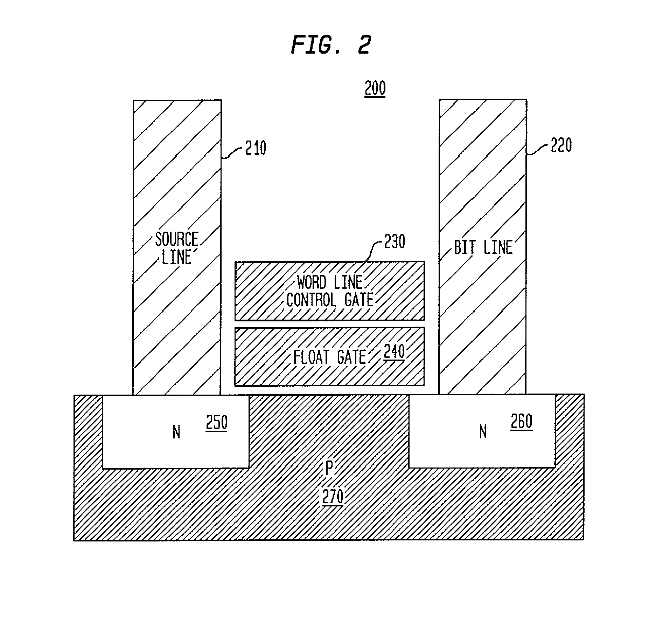

FIG. 2 shows an exemplary functional block diagram of a single flash memory cell that might be found in solid-state media **110.** Flash memory cell **200** is a MOSFET with two gates. The word line control gate **230** is located on top of floating gate **240.** Floating gate **240** is isolated by an insulating layer from word line control gate **230** and the MOSFET channel, which includes N-channels **250** and **260,** and P-channel **270.** Because floating gate **240** is electrically isolated, any charge placed on floating gate **240** will remain and will not discharge significantly, typically for many months. When floating gate **240** holds a charge, it partially cancels the electrical field from word line control gate **230** that modifies the threshold voltage of the cell. The threshold voltage is the amount of voltage applied to control gate **230** to allow the channel to conduct. The channel's conductivity determines the value stored in the cell, for example by sensing the charge on floating gate **240.**

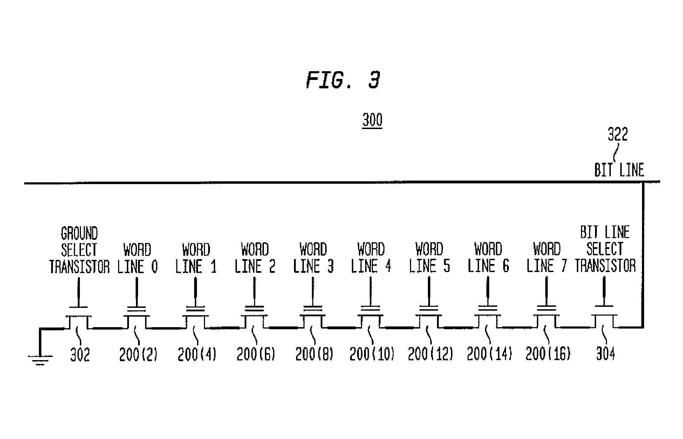

FIG. 3 shows an exemplary NAND MLC flash memory string **300** that might be found in solid-state media **110.** As shown in FIG. 3, flash memory string **300** might include one or more word line transistors **200(2), 200(4), 200(6), 200(8), 200(10), 200(12), 200(14),** and **200(16)** (e.g., 8 flash memory cells), and bit line select transistor **304** connected in series, drain to source. This series connection is such that ground select transistor **302,** word line transistors **200(2), 200(4), 200(6), 200(8), 200(10), 200(12), 200(14)** and **200(16),** and bit line select transistor **304** are all "turned on" (e.g., in either a linear mode or a saturation mode) by driving the corresponding gate high in order for bit line **322** to be pulled fully low. Varying the number of word line transistors **200(2), 200(4), 200(6), 200(8), 200(10), 200(12), 200(14),** and **200(16),** that are turned on (or where the transistors are operating in the linear or saturation regions) might enable MLC string **300** to achieve multiple voltage levels. A typical MLC NAND flash might employ a "NAND string" (e.g., as shown in FIG. 3) of 64 transistors with floating gates. During a write operation, a high voltage is applied to the NAND string in the word-line position to be written. During a read operation, a voltage is applied to the gates of all transistors in the NAND string except a transistor corresponding to a desired read location. The desired read location has a floating gate.

As described herein, in both SLC and MLC NAND flash, each cell has a voltage charge level (e.g., an analog signal) that can be sensed, such as by comparison with a read threshold voltage level. A media controller might have a given number of predetermined voltage thresholds employed to read the voltage charge level and detect a corresponding binary value of the cell. For example, for MLC NAND flash, if there are 3 thresholds (0.1, 0.2, 0.3), when a cell voltage level is 0.0 ≤ cell voltage < 0.1, the cell might be detected as having a value of [00]. If the cell voltage level is 0.1 ≤ cell voltage < 0.2, the value might be [10], and so on. Thus, a measured cell level might typically be compared to the thresholds one by one, until the cell level is determined to be in between two thresholds and can be detected. Thus, detected data values are provided to a decoder of memory controller **120** to decode the detected values (e.g., with an error-correction code) into data to be provided to host device **180.**

FIG. 4 shows a block diagram of an exemplary arrangement of solid-state media **110** of FIG. 1. As shown in FIG. 4, media **110** might be implemented with over-provisioning (OP) to prevent Out-of-Space (OOS) conditions from occurring. As shown in FIG. 4, OP might be achieved in three ways. First, SSD manufacturers typically employ the term "GB" to represent a decimal Gigabyte but a decimal Gigabyte (1,000,000,000 or 10⁹ bytes) and a binary Gibibyte (1,073,741,824 or 2³⁰ bytes) are not equal. Thus, since the physical capacity of the SSD is based on binary GB, if the logical capacity of the SSD is based on decimal GB, the SSD might have a built-in OP of 7.37% (e.g., [(2³⁰-10⁹)/10⁹]). This is shown in FIG. 4 as "7.37%" OP **402.** However, some of the OP, for example, 2-4% of the total capacity might be lost due to bad blocks (e.g., defects) of the NAND flash. Secondly, OP might be implemented by setting aside a specific amount of physical memory for system use that is not available to host device **180.** For example, a manufacturer might publish a specification for their SSD having a logical capacity of 100GB, 120GB or 128GB, based on a total physical capacity of 128GB, thus possibly achieving exemplary OPs of 28%, 7% or 0%, respectively. This is shown in FIG. 4 as static OP ("0 to 28+%") **404.**

Third, some storage protocols (e.g., SATA) support a "TRIM" command that enables host device **180** to designate blocks of previously saved data as unneeded or invalid such that NVM system **100** will not save those blocks during garbage collection. Prior to the TRIM command, if host device **180** erased a file, the file was removed from the host device records, but the actual contents of NVM system **100** were not actually erased, which cased NVM system **100** to maintain invalid data during garbage collection, thus reducing the NVM capacity. The OP due to efficient garbage collection by employing the TRIM command is shown in FIG. 4 as dynamic OP **406.** Dynamic OP **406** and user data **408** form the area of media **110** that contains active data of host device **180,** while OP areas **402** and **404** do not contain active data of host device **180.** The TRIM command enables an operating system to notify an SSD of which pages of data are now invalid due to erases by a user or the operating system itself. During a delete operation, the OS marks deleted sectors as free for new data and sends a TRIM command specifying one or more ranges of Logical Block Addresses (LBAs) of the SSD associated with the deleted sectors to be marked as no longer valid.

After performing a TRIM command, the media controller does not relocate data from trimmed LBAs during garbage collection, reducing the number of write operations to the media, thus reducing write amplification and increasing drive life. The TRIM command generally irreversibly deletes the data it affects. Examples of a TRIM command are the SATA TRIM (Data Set Management) command, the SCSI UNMAP command, the MultiMediaCard (MMC) ERASE command, and the Secure Digital (SD) card ERASE command. Generally, TRIM improves SSD performance such that a fully trimmed SSD has performance approaching that of a newly manufactured (i.e., empty) SSD of a same type.

In general, media controller **120** executes commands received from host device **180.** At least some of the commands write data to media **110** with data sent from host device **180,** or read data from media **110** and send the read data to host device **180.** Media controller **120** employs one or more data structures to map logical memory addresses (e.g., LBAs included in host operations) to physical addresses of the media. When an LBA is written in an SSD, the LBA is generally written to a different physical location each time, and each write updates the map to record where data of the LBA resides in the non-volatile memory (e.g., media **110**). For example, in a system such as described in International Patent Application no. PCT/US2012/049905 filed August 8, 2012, media controller **120** employs a multi-level map structure (e.g., map **144**) that includes a leaf level and one or more higher levels. The leaf level includes map pages that each has one or more entries. A logical address, such as an LBA of an attached media (e.g., media **110**), is looked up in the multi-level map structure to determine a corresponding one of the entries in a particular one of the leaf-level pages. The corresponding entry of the LBA contains information associated with the LBA, such as a physical address of media **110** associated with the LBA. In some implementations, the corresponding entry further comprises an indication as to whether the corresponding entry is valid or invalid, and optionally whether the LBA has had the TRIM command run on it ("trimmed") or has not been written at all. For example, an invalid entry is able to encode information, such as whether the associated LBA has been trimmed, in the physical location portion of the invalid entry.

To speed the look-up of LBAs, a cache (not shown) of at least some of the leaf-level pages might be maintained. In some embodiments, at least a portion of the map data structures are used for private storage that is not visible to host device **180** (e.g., to store logs, statistics, mapping data, or other private/control data of media controller **120**).

As described herein, map **144** converts between logical data addressing used by host device **180** and physical data addressing used by media **110.** For example, map **144** converts between LBAs used by host device **180** and block and/or page addresses of one or more flash dies of media **110.** For example, map **144** might include one or more tables to perform or look up translations between logical addresses and physical addresses.

Data associated with each LBA is stored at a corresponding physical address of media **110,** either in a fixed, non-compressed size, or in a respective, compressed size. As described herein, a read unit is a finest granularity of media **110** that is independently readable, such as a portion of a page of media **110.** The read unit might include (or correspond to) check bits and/or redundancy data of an error-correcting code (ECC) along with all data protected by the ECC. FIG. 5 illustrates selected details of an embodiment of mapping an LPN portion of an LBA by map **144.** As shown in FIG. 5, LBA **506** includes Logical Page Number (LPN) **502** and logical offset **504.** Map **144** translates LPN **502** into map data **512,** which includes read unit address **508** and length in read units **510** (and perhaps other map data, as indicated by the ellipsis). Map data **512** might typically be stored as a map entry into a map table of map **144.** Map **144** might typically maintain one map entry for each LPN actively in use by system **100.** As shown, map data **512** includes read unit address **508** and length in read units **510.** In some embodiments, a length and/or a span are stored encoded, such as by storing the length of the data associated with the LPN as an offset from the span in all (or a portion) of length in read units **510.** The span (or length in read units) specifies a number of read units to read to retrieve the data associated with the LPN, whereas the length (of the data associated with the LPN) is used for statistics, such as Block Used Space (BUS) to track an amount of used space in each block of the SSD. Typically, the length has a finer granularity than the span.

In some embodiments, a first LPN is associated with a first map entry, a second LPN (different from the first LPN, but referring to a logical page of a same size as the logical page referred to by the first LPN) is associated with a second map entry, and the respective length in read units of the first map entry is different from the respective length in read units of the second map entry. In such embodiments, at a same point in time, the first LPN is associated with the first map entry, the second LPN is associated with the second map entry, and the respective read unit address of the first map entry is the same as the respective read unit address of the second map entry such that data associated with the first LPN and data associated with the second LPN are both stored in the same physical read unit of media **110.**

In various embodiments, map **144** is one of: a one-level map; a two-level map including a first level map (FLM) and one or more second level (or lower level) maps (SLMs) to associate the LBAs of the host protocol with the physical storage addresses in media **110.** For example, as shown in FIG. 6, FLM **610** is maintained on-chip in media controller **120,** for example in map **144.** In some embodiments, a non-volatile (though slightly older) copy of FLM **610** is also stored on media **110.** Each entry in FLM **610** is effectively a pointer to a SLM page (e.g., one of SLMs **616).** SLMs **616** are stored in media **110** and, in some embodiments, some of the SLMs are cached in an on-chip SLM cache of map **144** (e.g., SLM cache **608).** An entry in FLM **610** contains an address (and perhaps data length/range of addresses or other information) of the corresponding second-level map page (e.g., in SLM cache **608** or media **110**). As shown in FIG. 6, map module **144** might include a two-level map with a first-level map (FLM) **610** that associates a first function (e.g., a quotient obtained when dividing the LBA by the fixed number of entries included in each of the second-level map pages) of a given LBA (e.g., LBA **602**) with a respective address in one of a plurality of second-level maps (SLMs) shown as SLM **616,** and each SLM associates a second function (e.g., a remainder obtained when dividing the LBA by the fixed number of entries included in each of the second-level map pages) of the LBA with a respective address in media **110** corresponding to the LBA.

For example, as shown in FIG. 6, translator **604** receives an LBA (LBA **602**) corresponding to a host operation (e.g., a request from host **180** to read or write to the corresponding LBA on media **110**). Translator **604** translates LBA **602** into FLM index **606** and SLM Page index **614,** for example, by dividing LBA **602** by the integer number of entries in each of the corresponding SLM pages **616.** In described embodiments, FLM index **606** is the quotient of the division operation, and SLM Page index **614** is the remainder of the division operation. Employing the dividing operation allows for SLM pages **616** to include a number of entries that is not a power of two, which might allow SLM pages **616** to be reduced in size, lowering write amplification of media **110** due to write operations to update SLM pages **616.** FLM index **606** is used to uniquely identify an entry in FLM **610,** the entry including an SLM page index **(614)** corresponding to one of SLM pages **616.** As indicated by **612,** in instances where the SLM page corresponding to the SLM page index of the FLM entry is stored in SLM cache **608,** FLM **610** might return the physical address of media **110** corresponding to LBA **602.** SLM page index **614** is used to uniquely identify an entry in SLM **616,** the entry corresponding to a physical address of media **110** corresponding to LBA **602,** as indicated by **618.** Entries of SLM **616** might be encoded as a read unit address (e.g., the address of an ECC-correctable sub-unit of a flash page) and a length of the read unit.

SLM pages **616** (or a lower-level of a multi-level map (MLM) structure) might all include the same number of entries, or each of SLM pages **616** (or a lower-level of a MLM structure) might include a different number of entries. Further, the entries of SLM pages **616** (or a lower-level of a MLM structure) might be the same granularity, or the granularity might be set for each of SLM pages **616** (or a lower-level of a MLM structure). In exemplary embodiments, FLM **610** has a granularity of 4KB per entry, and each of SLM pages **616** (or a lower-level of a MLM structure) has a granularity of 8KB per entry. Thus, for example, each entry in FLM **610** is associated with an aligned eight-sector (4KB) region of 512B LBAs and each entry in one of SLM pages **616** is associated with an aligned sixteen-sector (8KB) region of 512B LBAs.

In some embodiments, entries of FLM **610** (or a higher-level map of an MLM structure) include the format information of corresponding lower-level map pages. FIG. 7 shows a block diagram of exemplary FLM **700.** As shown, each of the *N* entries **701** of FLM **700** includes format information of a corresponding lower-level map page. As shown, FLM **700** might include SLM page granularity **702,** read unit physical address range **704,** data size for each LBA **706,** data invalid indicator **708,** TRIM operation in progress indicator **710,** TRIM LBA range **712** and To-Be-Processed (TBP) indicator **714.** Other metadata (not shown) might also be included. Map page granularity **702** indicates the granularity of the SLM page corresponding to the entry of FLM **700.** Read unit physical address range **704** indicates the physical address range of the read unit(s) of the SLM page corresponding to the entry of FLM **700,** for example as a starting read unit address and span. Data size for each LBA **706** indicates a number of read units to read to obtain data of associated LBAs or a size of data of the associated LBAs stored in media **110** for the SLM page corresponding to the entry of FLM **700.** Data invalid indicator **708** indicates that the data of the associated LBAs is not present in media **110,** such as due to the data of the associated LBAs already being trimmed or otherwise invalidated. In alternative embodiments, data invalid indicator might be encoded as part of read unit physical address range **704.** As will be described in greater detail below, TRIM operation in progress indicator **710** indicates that a TRIM operation is in progress on the LBAs indicated by TRIM LBA range **712.** In some embodiments, TRIM operation in progress indicator **710** might be encoded as part of TRIM LBA range **712.** TBP indicator **714** indicates when LBAs associated with the map page are already invalidated (e.g., appear trimmed to host **180**), but the LBAs are not yet available to be written with new data. In contrast with marking a higher-level map entry invalid, setting the TBP bit of the higher-level map entry does not imply that a physical address of the lower-level map page stored in the higher-level map entry is invalid - the physical address is required, and the lower-level map page itself cannot be de-allocated, until the lower-level map page is processed for BUS updates. Lower-level map pages thus might be in one of three states: invalid, valid, or TBP.

An SSD employing a multi-level map (MLM) structure such as described herein enables an improved TRIM operation that spans over multiple leaf-level map units. Thus, instead of invalidating individual LBA entries as for a standard TRIM operation, the improved TRIM operation can invalidate entire leaf units in a higher map level of the MLM structure. This reduces latency of the TRIM operation from perspective of a host device coupled to media controller **120,** advantageously allowing higher system performance. However, simply discarding individual trimmed LBA entries in the leaf-level maps could incur inaccuracy in Block Used Space (BUS) accounting, since trimmed LBAs still appear as contributing to BUS. The BUS count is maintained by media controller **120** in media **110** for each region of the non-volatile memory of the SSD, such as per flash block or group of flash blocks, as one way to determine when to perform garbage collection on a given block or group of blocks (e.g., the one with the least BUS) thus reducing garbage collection write amplification. Thus, an inaccuracy in BUS could result in inaccurate garbage collection and/or an increased number of writes to media **110,** thus increasing write amplification and reducing SSD life. The improved TRIM operation is able to perform fast trimming of LBAs while also maintaining BUS accuracy by updating the BUS count in the background after acknowledging the TRIM operation to the host device.

In described embodiments, the TRIM operation updates the MLM structure to mark all trimmed LBAs as invalid. Further, the TRIM operation subtracts flash space previously used by trimmed LBAs from the BUS count of corresponding regions of media 110 to provide accurate garbage collection. Thus, to trim a particular LBA properly, two things are done: the particular LBA is invalidated in MLM structures, and the BUS count is updated reflecting that the particular LBA no longer consumes flash space. However, for a large trim region (e.g., the entire SSD) or a plurality of large trim regions, the time required to perform the invalidations and the BUS updates can become large and negatively impact system performance.

As described herein, the SLM page information stored in the FLM might include an indication (e.g., To-Be-Processed (TBP) indicator **714**) indicating when LBAs within corresponding SLM pages are already invalidated (e.g., appear trimmed to host **180**), but the BUS update portion of the TRIM operation is not yet complete. In contrast with marking a higher-level map entry invalid, setting the TBP indicator of the higher-level map entry does not imply that a physical address of the lower-level map page stored in the higher-level map entry is invalid: the physical address is required, and the lower-level map page itself cannot be de-allocated, until the lower-level map page is processed for BUS updates. However, all user data associated with the higher-level map entry is invalid with respect to host read operations, the same as if the higher-level map entry was marked invalid.

The size of the data of the associated LBAs stored in media **110** (e.g., **706**) is used to update the BUS value for the corresponding regions when SSD **101** performs a TRIM operation. For example, the size values are subtracted from the BUS count of corresponding regions. In embodiments employing a MLM structure, updating the BUS count can be time consuming since updating the BUS count requires processing leaf-level map entries one by one. To improve processing time, described embodiments employ a Mega-TRIM operation that updates BUS counts of corresponding regions of media **110** in a background operation mode of SSD **101.**

For example, when SSD **101** receives a TRIM command from host **180,** media controller **120** performs a Mega-TRIM operation that sets the respective TBP indicator (e.g., **714**) of FLM entries (e.g., **701**) corresponding to SLM page(s) associated with the TRIM command. If the TRIM operation affects only a portion of the SLM entries in the SLM page, some embodiments might process the individual entries of the partial SLM page by updating each partial SLM page by marking the trimmed SLM entries invalid and updating the BUS count to reflect the trimmed portion of the SLM page. Other embodiments might defer updating the partial SLM pages by employing the TBP indicator (e.g., **714**), a TRIM operation in progress indicator (e.g., **710**) and TRIM LBA range (e.g., **712**)**,** allowing deferral of marking the trimmed SLM entries invalid and updating the BUS count. Then, a subsequent partial TRIM operation of a partially-trimmed SLM page optionally and/or selectively performs some or all of the update operations to the partially-trimmed SLM page immediately to avoid needing to track multiple sub-ranges in a given TRIM LBA range (e.g., **712**). However, alternative embodiments might track multiple sub-ranges in TRIM LBA range (e.g., **712**), allowing longer deferral of marking the trimmed SLM entries invalid and updating the BUS count.

When a Mega-TRIM operation is performed, after invalidating the associated LBAs, SSD 101 might acknowledge the TRIM command to host **180** before the BUS count is updated. Updating the BUS count is then performed in a background process of SSD **101** (typically completing within a range of several seconds to several minutes depending on TRIM range and the amount of activity initiated by host **180**). Each time one of the SLM pages having the TBP indicator set in the associated FLM entry is completely processed (e.g., marking the trimmed SLM entries invalid and updating the BUS count for all SLM entries in the trimmed SLM page), the TBP indicator in the associated FLM entry is cleared. If all of the SLM entries of one of the SLM pages are trimmed, the associated FLM entry is marked as trimmed, obviating a need to process the SLM page further until a new write validates at least one entry within the SLM page.

FIG. 8 shows a flow diagram of Mega-TRIM operation **800.** As shown in FIG. 8, at step **802** a TRIM operation request is received by SSD **101** from host **180.** At step **804,** SSD **101** determines a range of the TRIM operation (e.g., one or more starting LBAs and ending LBAs). SSD **101** might maintain a beginning TBP index (min_flm_index_tbt) and an ending TBP index (max_flm_index_tbt) of the FLM indicating portions of the FLM for which the TBP indicator is set, indicating the portion of the FLM requiring background operations to update the BUS count and make memory blocks of media **110** re-available to host **180.** In the background (e.g., during otherwise idle time of SSD **101**), SSD **101** might examine the FLM entry at the beginning TBP index and if TBP is set on that FLM entry, read the associated SLM page and trim that whole SLM page by updating the BUS count according to each entry in the associated SLM page, clearing the TBP indicator in the FLM entry, and marking the FLM entry as trimmed, indicating the entire SLM page is trimmed. The beginning TBP index (min_flm_index_tbt) is updated to indicate that the entry has been processed.

As shown in FIG. 8, when a TRIM command having a trim range (e.g., one of the 64-per-sector NCQ trim ranges for SATA) is processed, at step **806** SSD **101** determines whether at least one of the first SLM page of the TRIM range and the last SLM page of the TRIM range is a partial SLM page (e.g., the TRIM range only applies to part of the SLM page). If, at step **806,** there are partial SLM pages at the start or end of the range, then at step **808,** SSD **101** determines whether the partial SLM page is stored in cache **608.** If, at step **808,** the partial SLM page at the start or end of the TRIM range is stored in cache **608,** then process **800** proceeds to step **812.** If, at step **808,** the partial SLM page at the start or end of the TRIM range is not stored in cache **608,** then at step **810** SSD **101** fetches the partial SLM page from media **110** into cache **608** and process **800** proceeds to step **812.** At step **812,** the TRIM operation is performed for the entries of the partial SLM page that are within the range of the TRIM operation. For example, the SLM page entries in the TRIM range are updated corresponding to any LBAs in the TRIM range in the partial SLM page. Updating an entry in the SLM page includes setting the data invalid indicator and updating the BUS count. Process **800** proceeds to step **820.**

If, at step **806,** the SLM page is not a partial SLM page, at step **814,** SSD **101** determines whether the full SLM page is stored in cache **608.** If, at step **814,** the full SLM page is stored in cache **608,** then process **800** proceeds to step **816.** If, at step **814,** the full SLM page is not stored in cache **608,** then at step **818** SSD **101** sets the TBP indicator in the FLM corresponding to the SLM page (e.g., **714**). Process 800 proceeds to step **820.**

When an SLM page needs to be fetched from media **101,** if TBP is set in the associated FLM entry, then the SLM page is fully invalidated (all entries within the SLM page are treated as invalid with respect to host accesses), but the SLM page has not yet been processed for BUS update purposes. For a read, the SLM page is not needed (all data referenced by that SLM page is trimmed), and fetching the SLM page is not required. For a write, the SLM page is fetched, the BUS count is updated for all LBAs in the SLM page, all entries in the SLM page are invalidated, and then the SLM entries are updated within the SLM page that are being written. At step **816,** a subset of the operations for a write are performed: the BUS count is updated for all LBAs in the SLM page, and all entries in the SLM page are invalidated.

At step **822,** SSD **101** determines a range of entries of the FLM having the TBP indicator set (e.g., min_flm_index_tbt and max_flm_index_tbt), indicating the portion of the FLM requiring background operations to update the BUS count and make memory blocks of media **110** re-available to host **180.** At step **824,** the remainder of the TRIM operation (e.g., updating the BUS count and releasing the memory blocks as usable by host **180**) occurs in the background (e.g., during otherwise idle time of SSD **101**). SSD **101** might maintain one or more pointers that are updated as memory blocks are trimmed at step **816** (e.g., as their BUS count is updated) to ensure the new TRIM range is remembered as blocks are processed. For example, SSD **101** might examine the FLM entry at the beginning TBP index and if TBP is set on that FLM entry, read the associated SLM page and trim that whole SLM page by updating the BUS count, clearing the TBP indicator in the FLM entry, and marking the FLM entry as trimmed, indicating the entire SLM page is trimmed. The beginning TBP index (min_flm_index_tbt) is updated to indicate that the entry has been processed. When the background TRIM operation at step **824** is complete, the TRIM operation is acknowledged to host **180.** At step **826,** process **800** completes.

Thus, as described herein, described embodiments provide a media controller for a solid-state media. The media controller includes a control processor receives a request from a host device that includes at least one logical address and address range. In response to the request, the control processor determines whether the received request is an invalidating request. If the received request type is an invalidating request, the control processor uses a map of the media controller to determine one or more entries of the map associated with the logical address and range. Indicators in the map associated with each of the map entries are set to indicate that the map entries are to be invalidated. The control processor acknowledges to the host device that the invaliding request is complete and updates, in an idle mode of the media controller, a free space count based on the map entries that are to be invalidated. The physical addresses associated with the invalidated map entries are made available to be reused for subsequent requests from the host device.

Reference herein to "one embodiment" or "an embodiment" means that a particular feature, structure, or characteristic described in connection with the embodiment can be included in at least one embodiment. The appearances of the phrase "in one embodiment" in various places in the specification are not necessarily all referring to the same embodiment, nor are separate or alternative embodiments necessarily mutually exclusive of other embodiments. The same applies to the term "implementation."

As used in this application, the word "exemplary" is used herein to mean serving as an example, instance, or illustration. Any aspect or design described herein as "exemplary" is not necessarily to be construed as preferred or advantageous over other aspects or designs. Rather, use of the word exemplary is intended to present concepts in a concrete fashion.

While the exemplary embodiments have been described with respect to processing blocks in a software program, including possible implementation as a digital signal processor, micro-controller, or general-purpose computer, described embodiments are not so limited. As would be apparent to one skilled in the art, various functions of software might also be implemented as processes of circuits. Such circuits might be employed in, for example, a single integrated circuit, a multi-chip module, a single card, or a multi-card circuit pack.

Described embodiments might also be embodied in the form of methods and apparatuses for practicing those methods. Described embodiments might also be embodied in the form of program code embodied in non-transitory tangible media, such as magnetic recording media, optical recording media, solid state memory, floppy diskettes, CD-ROMs, hard drives, or any other non-transitory machine-readable storage medium, wherein, when the program code is loaded into and executed by a machine, such as a computer, the machine becomes an apparatus for practicing described embodiments. Described embodiments might can also be embodied in the form of program code, for example, whether stored in a non-transitory machine-readable storage medium, loaded into and/or executed by a machine, or transmitted over some transmission medium or carrier, such as over electrical wiring or cabling, through fiber optics, or via electromagnetic radiation, wherein, when the program code is loaded into and executed by a machine, such as a computer, the machine becomes an apparatus for practicing the described embodiments. When implemented on a general-purpose processor, the program code segments combine with the processor to provide a unique device that operates analogously to specific logic circuits. Described embodiments might also be embodied in the form of a bitstream or other sequence of signal values electrically or optically transmitted through a medium, stored magnetic-field variations in a magnetic recording medium, etc., generated using a method and/or an apparatus of the described embodiments.

It should be understood that the steps of the exemplary methods set forth herein are not necessarily required to be performed in the order described, and the order of the steps of such methods should be understood to be merely exemplary. Likewise, additional steps might be included in such methods, and certain steps might be omitted or combined, in methods consistent with various described embodiments.

As used herein in reference to an element and a standard, the term "compatible" means that the element communicates with other elements in a manner wholly or partially specified by the standard, and would be recognized by other elements as sufficiently capable of communicating with the other elements in the manner specified by the standard. The compatible element does not need to operate internally in a manner specified by the standard. Unless explicitly stated otherwise, each numerical value and range should be interpreted as being approximate as if the word "about" or "approximately" preceded the value of the value or range.

Also for purposes of this description, the terms "couple," "coupling," "coupled," "connect," "connecting," or "connected" refer to any manner known in the art or later developed in which energy is allowed to be transferred between two or more elements, and the interposition of one or more additional elements is contemplated, although not required. Conversely, the terms "directly coupled," "directly connected," etc., imply the absence of such additional elements. Signals and corresponding nodes or ports might be referred to by the same name and are interchangeable for purposes here.

It will be further understood that various changes in the details, materials, and arrangements of the parts that have been described and illustrated in order to explain the nature of the described embodiments might be made by those skilled in the art without departing from the scope expressed in the following claims.

## Claims

1. A method of processing host requests received by a media controller in communication with a solid-state media and a host device, the method comprising:
receiving, by the media controller, a request from the host device, the request including at least one logical address and address range;
in response to receiving the request:
determining whether the received request is an invalidating request, and if the received request type is an invalidating request:
determining, employing a map of the media controller, one or more entries of the map associated with the at least one logical address and address range of the solid-state media;
marking, in the map, indicators associated with each of the map entries, the indicators indicating that the one or more map entries are to be invalidated;
acknowledging, to the host device, the invaliding request as complete;
updating, in an idle mode of the media controller, a free space count of the media controller based on the one or more map entries that are to be invalidated; and
making the physical addresses associated with the invalidated map entries available to be reused for subsequent requests from the host device.

2. The method of claim 1, wherein the map is a multi-level map comprising a first-level map and a second-level map, the method further comprising:
associating each of a plurality of entries of a plurality of second-level map pages with a physical address of the solid state media; and
associating each of a plurality of entries of the first-level map with a second-level map page, thereby associating the at least one logical address and address range to at least one of the second-level map entries.

3. The method of claim 2:
wherein:
each second-level map entry comprises a valid indication; and
each first-level map entry comprises an address of a corresponding one of the second-level map pages, a valid indication corresponding to one or more entries of the second-level map associated with the first-level map entry, and a To-Be-Processed (TBP) indicator configured to indicate when entries of the second-level map are invalid but not available to be written;
the method further comprising:
invalidating entries of the second-level map by setting particular ones of the TBP indicators in the first-level map associated with ones of the second-level map pages that are entirely within the address range of the request.

4. The method of claim 3, the method further comprising:
invalidating entries of the second-level map by directly trimming entries of ones of the second-level map pages that are only partially within the address range of the request.

5. The method of claim 3, wherein, if the TBP indicator is set for a given second-level map, the method further comprises:
deferring processing the invalidating request for the given second-level map until a subsequent invalidating request is received for the given second-level map, thereby reducing processing time for the invalidating request and reducing write operations to the solid state media to update the given second-level map.

6. The method of claim 3, wherein the step of making each of the invalidated entries of the second-level map available to be reused for subsequent requests from the host device comprises:
if set, clearing the associated TBP indicator; and
if set, clearing the associated valid indicator.

7. The method of claim 3, further comprising:
storing the first-level map in a map memory of the media controller;
storing all of the second-level map pages in the solid state media; and
storing at least a subset of the second-level map pages temporarily in a map cache coupled to a control processor of the media controller.

8. The method of claim 1, wherein the free space count of the media controller comprises a block used space table having a plurality of entries, the method further comprising:
associating each entry of the block used space table with one of a plurality of physical regions of the solid state media.

9. The method of claim 1, wherein the invalidating request is one of a Serial Advanced Technology Attachment (SATA) TRIM command, a Small Computer System Interface (SCSI) UNMAP command, a MultiMediaCard (MMC) ERASE command, and a Secure Digital (SD) card ERASE command.

10. The method of claim 3, wherein each first-level map entry comprises at least one TRIM address range indicator configured to track portions of the associated second-level maps that are within the range of the request.

11. A media controller for a solid-state media, the media controller in communication with a host device, the media controller comprising:
a control processor configured to, in response to receiving a request from the host device, the request including at least one logical address and address range:
determine whether the received request is an invalidating request, and if the received request type is an invalidating request:
determine, by a map of the media controller, one or more entries of the map associated with the at least one logical address and address range of the solid-state media;
mark, in the map, indicators associated with each of the map entries, the indicators indicating that the one or more map entries are to be invalidated;
acknowledge, to the host device, the invaliding request as complete;
update, in an idle mode of the media controller, a free space count of the media controller based on the one or more map entries that are to be invalidated; and
make the physical addresses associated with the invalidated map entries available to be reused for subsequent requests from the host device.

12. The media controller of claim 11, wherein the map is a multi-level map, the multi-level map comprising:
a second-level map having a plurality of second-level map pages, each of the second-level map pages having a plurality of entries, each entry configured to store a physical address of the solid state media; and
a first-level map having a plurality of entries, each entry associated with a second-level map page, the first-level map configured to associate the at least one logical address and address range to at least one of the second-level map entries.

13. The media controller of claim 12, wherein:
each second-level map entry comprises a valid indication; and
each first-level map entry comprises an address of a corresponding one of the second-level map pages, a valid indication corresponding to one or more entries of the second-level map associated with the first-level map entry, and a To-Be-Processed (TBP) indicator configured to indicate when entries of the second-level map are invalid but not available to be written.

14. The media controller of claim 13, wherein, to invalidate the entries of the second-level map; the control processor is configured to:
set particular ones of the TBP indicators in the first-level map associated with ones of the second-level map pages that are entirely within the address range of the request.

15. The media controller of claim 11, wherein the free space count of the media controller comprises a block used space table having a plurality of entries, each entry of the block used space table associated with one of a plurality of physical regions of the solid state media.
